# FASCICULE DE BREVET EUROPEEN

(11) **EP 4 552 152 B1**
(45) Date de publication et mention de la délivrance du brevet: **24.06.2026**
(21) Numéro de dépôt: 23734569.9
(22) Date de dépôt: 20.06.2023
(51) Int. Cl.: H10P 90/00, H10W 10/10

(54) **PROCEDE DE FABRICATION D'UNE STRUCTURE COMPORTANT UNE COUCHE BARRIERE A LA DIFFUSION D'ESPECES ATOMIQUES**
VERFAHREN ZUR HERSTELLUNG EINER STRUKTUR MIT EINER SCHICHT ALS BARRIERE GEGEN DIFFUSION VON ATOMAREN SPEZIES
PROCESS FOR FABRICATING A STRUCTURE COMPRISING A LAYER THAT ACTS AS A BARRIER TO DIFFUSION OF ATOMIC SPECIES

(30) Priorité: 04.07.2022 FR 2206733
(43) Date de publication de la demande: 14.05.2025
(73) Titulaire: SOITEC, 38190 Bernin (FR)
(72) Inventeur: BROEKAART, Marcel, 38190 Bernin (FR); GUERIN, Rénald, 38190 Bernin (FR); LOGIOU, Morgane, 38190 Bernin (FR); BERTRAND, Isabelle, 38190 Bernin (FR)
(74) Mandataire: IP Trust
(86) Numéro de dépôt international: PCT/EP2023/066668
(87) Numéro de publication internationale: WO 2024/008441

(56) Documents cités:
- WO-A1-2022/023630
- FR-A1- 3 094 573
- US-A1- 2010 187 649
- US-A1- 2018 114 720
- US-A1- 2018 158 721
- US-A1- 2020 027 778
- US-B2- 10 546 771

## Description

### DOMAINE DE L'INVENTION

L'invention concerne un procédé de fabrication d'une structure comprenant une couche mince reportée sur un support muni d'une couche de piégeage de charges. L'invention trouve son application notamment dans les domaines de la microélectronique, des microsystèmes, de la photonique...

### ARRIERE PLAN TECHNOLOGIQUE DE L'INVENTION

Le document WO2021008742 rappelle qu'il est souvent avantageux de prévoir une couche de piégeage de charges électriques (plus concisément désignée « couche de piégeage » dans la suite de cette description) dans le support d'une structure formée d'une couche mince reportée, par l'intermédiaire d'une couche diélectrique, sur ce support. La fabrication de ce type de structure est par exemple décrite dans les documents FR2860341, FR2933233, FR2953640, US2015115480, US7268060 ou US6544656. Elle trouve notamment une application pour la formation de composants électroniques ou électroacoustiques dans le domaine des signaux radiofréquences (RF).

La couche mince, souvent monocristalline, peut être de nature semi-conductrice (par exemple du silicium) ou isolante (par exemple un matériau piézoélectrique, tel que du tantalate de lithium ou du niobate de lithium).

Le document précité expose également que ce type de structure est particulièrement sensible à l'hydrogène, cette espèce atomique pouvant diffuser et se figer dans la couche de piégeage, ce qui tend à passiver les défauts électriques que cette couche comprend et, en conséquence, à dégrader les performances RF de la structure. Comme cela est documenté dans la publication « White paper - RF SOI Characterisation » de janvier 2015 et publié par la société SOITEC, la performance RF d'un substrat peut être caractérisée par une mesure de distorsion de seconde harmonique.

La demanderesse a également observé que lorsque la couche mince comprenait du lithium, cette espèce atomique était également susceptible de diffuser dans la structure au cours des étapes de sa fabrication pour se figer dans la couche de piégeage et la doper. Tout comme pour l'hydrogène, la présence de lithium dans la couche de piégeage tend à dégrader les performances RF de la structure.

Pour prévenir la dégradation des performances RF engendrée par la diffusion d'espèces atomiques (notamment d'hydrogène) dans une structure comportant une couche de piégeage, le document WO2021008742 propose d'intégrer une barrière de diffusion dans la couche diélectrique.

D'autres documents pertinents sont FR3094573 A1, WO2022023630 A1 et US2018114720 A1.

### OBJET DE L'INVENTION

Un but de l'invention est d'améliorer cet état de la technique en proposant un procédé particulièrement simple et efficace pour incorporer une barrière de diffusion à certaines espèces atomiques, notamment d'hydrogène et/ou de lithium, dans une structure comprenant une couche de piégeage de charges.

### BREVE DESCRIPTION DE L'INVENTION

En vue de la réalisation de ce but, l'objet de l'invention propose un procédé de fabrication d'une structure comprenant une couche mince reportée sur un support par l'intermédiaire d'une couche diélectrique, le support comprenant une couche de piégeage de charges électriques disposée superficiellement sur un substrat de base, le procédé comportant les étapes suivantes :
- former une couche diélectrique sur une surface exposée d'une face dite « principal » du support et/ou sur une surface exposée d'une face dite « principale » d'un substrat donneur ;
- appliquer un traitement de surface à la surface exposée de la face principale du support et/ou à la surface exposée de la face principale du substrat donneur en vue d'y former une couche barrière à la diffusion de certaines espèces atomiques ;
- assembler le support et le substrat donneur par leurs faces principales respectives afin de constituer une structure intermédiaire;
éliminer une partie au moins du substrat donneur de la structure intermédiaire pour former la couche mince.

Le procédé est remarquable en ce que le traitement de surface appliqué à l'une au moins des surfaces exposées comprend :
- l'exposition de la surface exposée à un plasma comprenant de l'oxygène pour former une épaisseur endommagée sous la surface principale, puis
- l'exposition de la surface exposée à un plasma comprenant de l'azote pour nitrurer l'épaisseur endommagée.

Un tel traitement de surface permet de former, simplement, une couche barrière à la diffusion de certaines espèces atomiques, particulièrement efficace notamment vis-à-vis de la diffusion de l'hydrogène et/ou du lithium. On évite ainsi de fournir une structure aux performances RF dégradées.

Selon d'autres caractéristiques avantageuses et non limitatives de l'invention, prises seules ou selon toute combinaison techniquement réalisable :
- le substrat donneur comprend un matériau piézoélectrique monocristallin ;
- le substrat donneur est un substrat de silicium monocristallin ;
- le substrat de base est un substrat de silicium monocristallin ;
- la couche diélectrique comprend de l'oxyde de silicium ;
- la couche de piégeage est en silicium polycristallin ;
- la formation de la couche diélectrique comprend l'oxydation de la couche de piégeage ;
- la formation de la couche diélectrique précède l'application du traitement de surface sur la surface exposée de la face principale du support ;
- la couche diélectrique succède à l'application du traitement de surface sur la surface exposée de la face principale du support ;
- la couche diélectrique en oxyde de silicium incorpore de l'azote, préférentiellement dans un ratio azote/oxygène inférieur à 0,5 ;
- la formation de la couche diélectrique comprend la formation d'une partie au moins de la couche diélectrique sur le substrat donneur ;
- l'application du traitement de surface comprend son application à la surface exposée de la face principale du substrat donneur ;
- la formation d'une partie au moins de la couche diélectrique sur le substrat donneur précède l'application du traitement de surface.

### BREVE DESCRIPTION DES FIGURES

D'autres caractéristiques et avantages de l'invention ressortiront de la description détaillée de l'invention qui va suivre en référence aux figures annexées sur lesquels :
[Fig.1] La [Fig.1] représente une structure conforme à l'invention ;
[Fig.2] La [Fig.2] représente les séquences d'un procédé de fabrication d'une structure conforme à l'invention ;
[Fig.3] La [Fig.3] représente les sous-étapes composant le traitement de surface visant à former une couche barrière dans un procédé de fabrication d'une structure conforme à l'invention.

### DESCRIPTION DETAILLEE DE L'INVENTION

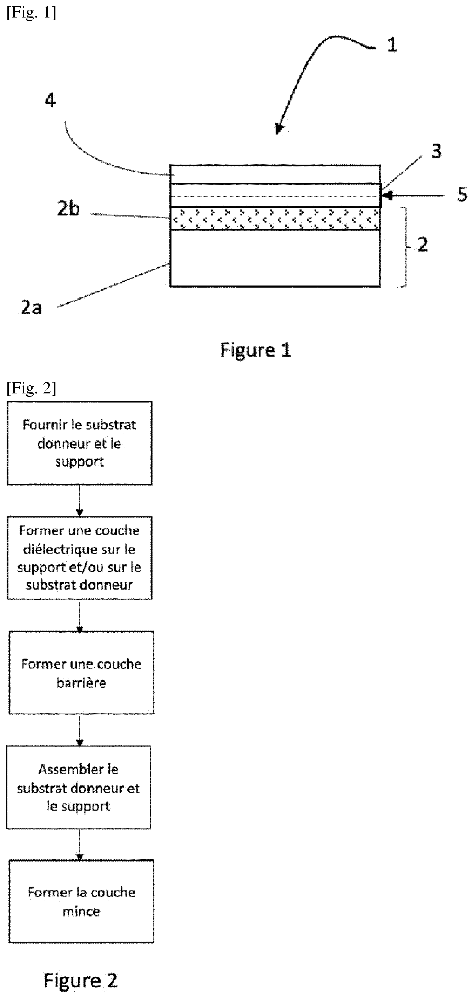

D'une manière très générale et en référence à la [Fig.1], la présente description porte sur un procédé de fabrication d'une structure 1 comprenant successivement une couche mince nanocristalline 4, une couche diélectrique 3 et un support 2. Le support 2 comprend lui-même un substrat de base 2a muni d'une couche de piégeage de charges électriques 2b. Préférentiellement la couche diélectrique 3 et en contact avec la couche de piégeage 2b et avec la couche mince 4. Comme cela a été exposé dans l'introduction de cette demande, une telle structure 1 est particulièrement adaptée à recevoir, sur ou dans la couche mince 4, des composants radiofréquences (RF).

Pour prévenir la diffusion de certaines espèces atomiques vers la couche de piégeage 2b, la structure 1 comprend une couche barrière 5 disposée dans la couche diélectrique 3 sur la structure 1 représentée sur la [Fig.1]. Comme cela sera exposé dans la suite de cette description, on peut également prévoir, en complément ou en remplacement de la couche barrière disposée dans la couche diélectrique, de la disposer superficiellement dans, ou sur, le support 2 lui-même, voire même sur ou dans la couche mince 4 (du côté de la couche diélectrique 3). La ou les couche(s) barrière(s) présentent une épaisseur de l'ordre de 5nm, typiquement comprise entre 2nm et 10nm, et est riche en azote.

Les espèces atomiques susceptibles de diffuser vers la couche de piégeage 2b peuvent notamment provenir de la couche mince 4. Il peut dans ce cas s'agir, à titre d'exemple, de lithium, lorsque cette couche mince 4 est constituée de tantalate de lithium ou de niobate de lithium (ou plus généralement de tout matériau à base de lithium). En prévoyant une couche barrière 5 apte à bloquer la diffusion lithium entre la couche mince 4 et la couche de piégeage 2b, on évite la dégradation des performances RF de la structure 1.

Les espèces atomiques peuvent également provenir de la couche diélectrique 3. C'est notamment le cas lorsque cette couche est réalisée, au moins en partie, par des techniques de dépôt mettant en œuvre des traitements thermiques modérés, inférieurs à 1000°C. Ces traitements ne permettent pas d'exodiffuser certaines espèces, telles que des espèces d'hydrogène, de la couche déposée et celles-ci restent donc susceptibles de diffuser au cours des autres étapes de fabrication de la structure 1, vers la couche de piégeage 2b. A nouveau, la présence de la barrière 5 permet de bloquer la diffusion de ces espèces vers la couche de piégeage 2b et prévenir la dégradation des performances RF de la structure 1.

De manière conventionnelle, la structure 1 peut se présenter sous la forme d'une plaquette circulaire dont le diamètre peut être de 100, 150 200, 300 voire même 450mm.

Le substrat de base 2a du support 2 sur lequel repose la couche de piégeage 2b présente typiquement une épaisseur de plusieurs centaines de microns. Préférentiellement, le substrat de base 2a présente une résistivité élevée, supérieure à 1000 ohms centimètres, et plus préférentiellement encore, supérieure à 2000 ohms centimètres. On limite de la sorte la densité des charges, trous ou électrons, qui sont susceptibles de se déplacer dans le substrat de base. Mais l'invention n'est pas limitée à un substrat de base 2a présentant une telle résistivité, et elle procure également des avantages de performance RF lorsque le substrat de base présente une résistivité plus conforme, de l'ordre de quelques centaines d'ohms centimètres, par exemple inférieur à 1000 ohm.cm, ou à 500 ohm.cm voire même à 10 ohm.cm.

Pour des raisons de disponibilité et de coût, le substrat de base 2a est préférentiellement en silicium monocristallin. Il peut s'agir par exemple d'un substrat de silicium CZ à faible teneur en oxygène interstitiel comprise entre 6 et 10 ppm, ou d'un substrat de silicium FZ qui présente notamment une teneur en oxygène interstitiel naturellement très faible. Il peut également s'agir d'un substrat de silicium CZ présentant une quantité élevée d'oxygène interstitiel (désigné par l'expression « High Oi ») supérieure à 26 ppm. Le substrat de base 2a peut alternativement être formé d'un autre matériau : il peut s'agir par exemple de saphir, de verre, de quartz, de carbure de silicium... Dans certaines circonstances, et notamment lorsque la couche de piégeage 2b présente une épaisseur suffisante, par exemple supérieur à 30 microns, le substrat de base 2a peut présenter une résistivité standard, inférieure à 1 kohm.cm.

La couche de piégeage 2b peut être de nature très variée, ainsi que cela est reporté dans les documents formant l'état de la technique. D'une manière générale, il s'agit d'une couche non monocristalline présentant des défauts structurels tels que des dislocations, des joints de grains, des zones amorphes, des interstices, des inclusions, des pores... Ces défauts structurels forment des pièges pour les charges susceptibles de circuler dans le matériau, par exemple au niveau de liaisons chimiques non complètes ou pendantes. On prévient ainsi la conduction dans la couche de piégeage qui présente en conséquence une résistivité élevée.

De manière avantageuse, et pour des raisons de simplicité de mise en œuvre, cette couche de piégeage 2b est formée d'une couche de silicium polycristallin. Cette couche peut être formée par dépôt sur le substrat de base 2a. Son épaisseur, notamment lorsqu'elle est formée sur un substrat de base 2a résistif, peut être comprise entre 0,1 à 3 µm. Mais d'autres épaisseurs inférieures ou supérieures à cet intervalle sont tout à fait envisageables, selon le niveau de performance RF attendu de la structure 1.

Afin de chercher à préserver la qualité polycristalline de cette couche au cours des traitements thermiques que peut subir la structure 1, on peut avantageusement prévoir une couche amorphe, en dioxyde de silicium par exemple, sur le substrat de base 2a avant le dépôt de la couche de piégeage 2b.

On peut alternativement former la couche de piégeage 2b par une implantation d'espèce relativement lourde, tel que de l'argon, dans une épaisseur superficielle du substrat de base 2a, afin d'y former les défauts structurels constituant les pièges électriques. On peut également former cette couche 2b par porosification d'une épaisseur superficielle du substrat de base 2a ou par toute autre méthode apte à former des défauts structurels dans une épaisseur superficielle du substrat de base 2a, ces défauts structurels étant aptes à piéger des charges électriques.

La couche diélectrique 3 est préférentiellement en oxyde de silicium. D'autres éléments chimiques peuvent également y être incorporés, sous forme de traces ou dans des concentrations plus importantes. Cette couche peut notamment incorporer de l'azote (pour former une couche de SiON), par exemple dans un dans un ratio azote/ oxygène inférieur à 0,5. Pour caractériser la proportion d'azote dans la couche, on pourra s'appuyer sur une mesure de son indice de réfraction qui évolue (à une longueur d'onde de 620nm) entre 1,44 pour du SiO2 à 2,35 pour du Si3N4.

La couche mince 4 de la structure 1 peut être de toute nature qui convient. Lorsque la structure 1 est destinée à recevoir des composants intégrés à semi-conducteur, la couche mince 4 peut être ainsi composée de silicium monocristallin, ou de tout autre matériau semi-conducteur monocristallin tel que du germanium, du silicium germanium du carbure de silicium. Lorsque la structure 1 est destinée à recevoir des filtres à onde acoustique de surface, la couche mince 4 peut être composée d'un matériau piézoélectrique et/ou ferroélectrique, monocristallin, tel que du tantalate de lithium ou du niobate de lithium. La couche mince 4 peut également comprendre des composants intégrés finis ou semi-finis, formés sur le substrat donneur et reportés sur le support 2 au cours de l'étape de fabrication de la structure 1. D'une manière générale, la couche mince peut présenter une épaisseur comprise entre 10nm et 10 microns.

Ainsi que cela est présenté dans les documents formant l'état de la technique présenté en préambule, la structure 1 peut être réalisée de multiples manières. Très généralement, et en référence à la [Fig.2], la structure 1 peut être réalisée par un procédé de fabrication comprenant :
- la fourniture du support et du substrat donneur ;
- la formation d'une couche diélectrique sur une surface exposée d'une face dite « principal » du support et/ou sur une surface exposée d'une face dite « principale » d'un substrat donneur ;
- l'application d'un traitement de surface à la surface exposée de la face principale du support et/ou à la surface exposée de la face principale du substrat donneur en vue d'y former la couche barrière ;
- l'assemblage du support et du substrat donneur par leurs faces principales respectives afin de constituer une structure intermédiaire ;
- de l'élimination d'une partie du substrat donneur de la structure intermédiaire pour former la couche mince 4 reposant sur le support par l'intermédiaire de la couche diélectrique.

La couche diélectrique peut être réalisée par dépôt, par exemple selon une technique LPCVD (acronyme de l'expression anglo-saxonne « Low Pressure Chemical Vapor Deposition » ou dépôt chimique en phase vapeur à pression sous atmosphérique) ou PECVD (acronyme de l'expression anglo-saxonne « Plasma Enhanced Chemical Vapor Deposition » ou dépôt chimique en phase vapeur assisté par plasma). Il peut également s'agir d'une technique HDP CVD (acronyme de l'expression anglo-saxonne « High Density Plasma Chemical Vapor Deposition » ou dépôt chimique en phase vapeur à haute densité de plasma).

.

Une couche diélectrique 3 d'oxyde de silicium peut être obtenue par oxydation du substrat donneur lorsque celui-ci est en silicium ou par oxydation de la couche de piégeage 2 lorsque celle-ci est également en silicium. Dans ce deuxième cas, on peut faire suivre l'oxydation par une étape de polissage de la surface oxydée afin de faciliter l'assemblage ultérieur du substrat donneur et du substrat support 2.

L'étape d'assemblage est avantageusement mise en œuvre par adhésion moléculaire. Comme cela est bien connu en soi, au cours d'un procédé d'adhésion moléculaire, les surfaces exposées du support et du substrat donneur, parfaitement propres, planes et lisses, sont mises en contact intime l'une avec l'autre pour favoriser le développement de liaisons moléculaires, par exemple de type van der Waals ou covalentes. L'assemblage des deux corps est alors obtenu sans utilisation d'un adhésif. Ces liaisons peuvent être renforcées par l'application d'un traitement thermique à la structure intermédiaire.

L'étape d'élimination d'une partie du substrat donneur peut être réalisée par amincissement mécano-chimique de ce substrat. Préférentiellement, la structure 1 est fabriquée par application de la technologie Smart Cut^{™}, selon laquelle une couche destinée à former la couche mince 4 est délimitée par l'intermédiaire d'un plan de fragilisation formé par implantation d'espèces légères (typiquement de l'hydrogène et/ou de l'hélium) dans le substrat donneur. Après l'étape d'assemblage, cette couche est prélevée du substrat donneur par fracture au niveau du plan de fragilisation et ainsi reportée sur le support 2.

On détaille maintenant les étapes composant le traitement de surface visant à créer simplement la couche barrière 5 dans la structure 1 au cours de sa fabrication.

Comme on l'a vu, ce traitement de surface est appliqué à la surface exposée de la face principale du support et/ou à la surface exposée de la face principale du substrat donneur.

Lorsqu'une couche diélectrique a été préalablement formée sur la face principale de l'un de ces deux éléments, par dépôt ou par oxydation, la surface exposée sur laquelle est appliqué le traitement de surface correspond donc à la surface exposée de la couche diélectrique. Mais d'une manière très générale, le traitement de surface peut être appliqué à l'un et/ou à l'autre du substrat donneur et du support, que ceux-ci présentent ou non une couche diélectrique superficielle.

On peut également prévoir d'appliquer le traitement de surface sur la surface exposée du support et/ou du substrat donneur avant de procéder au dépôt sur cette face d'une couche diélectrique.

Pour lever toute ambiguïté, on précise donc que le traitement de surface conduisant à former la couche barrière 5 peut être appliqué au substrat donneur uniquement, au support uniquement, ou à l'un et à l'autre de ces substrats. La formation de la couche diélectrique peut précéder l'application du traitement de surface ou lui succéder.

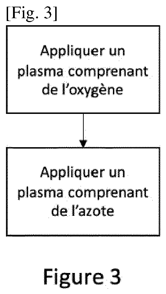

Que ce traitement de surface soit effectué sur l'un et/ou l'autre de ces deux substrats, celui-ci est composé de 2 sous-étapes successives, comme cela est représenté sur la [Fig.3]. Au cours d'une première sous-étape, on expose la surface exposée a un plasma comprenant de l'oxygène. Cette première sous étape conduit à former une couche poreuse (ou plus généralement) endommagée de faible épaisseur (de l'ordre de 5nm, typiquement compris entre 2nm et 10nm) en surface ou enterrée à très faible profondeur de la surface. Le plasma auquel a été exposée la surface du substrat au cours de cette première étape peut consister en un plasma d'oxygène où en un plasma d'oxygène combiné a de l'hexafluorure de soufre (SF6) ou à un gaz dont la formule générale est CₓH_{y}F_{z}.

Au cours d'une seconde sous-étape qui succède à la première sous étape, on expose la surface exposée du substrat traité à un plasma comprenant de l'azote. La seconde sous-étape permet d'introduire une grande quantité d'azote dans la couche endommagée formée au cours de la première sous étape. Le plasma auquel est exposée la surface du substrat au cours de la seconde sous-étape peut être constitué d'azote.

Il n'est pas nécessaire que ces 2 étapes soient réalisées in situ, et il est possible d'exposer le substrat donneur ou le support à l'atmosphère entre la première et la seconde sous-étape.

Les sous-étapes d'exposition aux plasmas peuvent consister à placer le substrat concerné dans une chambre d'un équipement d'activation plasma, par exemple sur un support plan disposé dans la chambre, de manière à exposer la face principale au plasma préparée par une source. Un flux à base d'oxygène (première sous étape) ou d'azote (seconde sous étape) est introduit dans la source plasma de l'équipement avec un débit maitrisé et un plasma de ce gaz est généré, par exemple par l'intermédiaire de champs magnétiques ou électriques variables. Les espèces du plasma sont projetées sur la surface exposée. Ces opérations peuvent être opérées à pression atmosphérique ou sous-atmosphérique.

Cette séquence de sous étape permet de produire très simplement une barrière relativement fine, de l'ordre de 5 nanomètres, qui incorpore une grande quantité d'azote ce qui rend son efficacité particulièrement importante. Elle permet notamment de rendre cette barrière bien plus efficace pour bloquer la diffusion de certaines espèces atomiques en comparaison avec une barrière uniquement formée par l'exposition à un unique plasma d'azote.

Bien entendu l'invention n'est pas limitée au mode de mise en œuvre décrit et on peut y apporter des variantes de réalisation sans sortir du cadre de l'invention tel que défini par les revendications.

## Revendications

1. Procédé de fabrication d'une structure (1) comprenant une couche mince (4) reportée sur un support (2) par l'intermédiaire d'une couche diélectrique (3), le support comprenant une couche de piégeage de charges électriques (2b) disposée superficiellement sur un substrat de base (2a), le procédé comportant les étapes suivantes :
- former une couche diélectrique (3) sur une surface exposée d'une face dite « principal » du support et/ou sur une surface exposée d'une face dite « principale » d'un substrat donneur ;
- appliquer un traitement de surface à la surface exposée de la face principale du support et/ou à la surface exposée de la face principale du substrat donneur en vue d'y former une couche barrière à la diffusion de certaines espèces atomiques ;
- assembler le support et le substrat donneur par leurs faces principales respectives afin de constituer une structure intermédiaire;
- éliminer une partie au moins du substrat donneur de la structure intermédiaire pour former la couche mince ;
le procédé étant **caractérisé en ce que** le traitement de surface appliqué à l'une au moins des surfaces exposées comprend :
- l'exposition de la surface exposée à un plasma comprenant de l'oxygène pour former une épaisseur endommagée sous la surface principale, puis
- l'exposition de la surface exposée à un plasma comprenant de l'azote pour nitrurer l'épaisseur endommagée.

2. Procédé de fabrication selon la revendication précédente dans lequel le substrat donneur comprend un matériau piézoélectrique monocristallin.

3. Procédé de fabrication selon la revendication 1 dans lequel le substrat donneur est un substrat de silicium monocristallin.

4. Procédé de fabrication selon l'une des revendications précédentes dans lequel le substrat de base (2a) est un substrat de silicium monocristallin.

5. Procédé de fabrication selon l'une des revendications précédentes dans lequel la couche diélectrique (3) comprend de l'oxyde de silicium.

6. Procédé de fabrication selon l'une des revendications précédentes dans lequel la couche de piégeage (2b) est en silicium polycristallin.

7. Procédé de fabrication selon la revendication précédente dans lequel la formation de la couche diélectrique (3) comprend l'oxydation de la couche de piégeage (2b).

8. Procédé de fabrication selon la revendication précédente dans lequel la formation de la couche diélectrique (3) précède l'application du traitement de surface sur la surface exposée de la face principale du support (2).

9. Procédé de fabrication selon la revendication 7 dans lequel la formation de la couche diélectrique (3) succède à l'application du traitement de surface sur la surface exposée de la face principale du support (2).

10. Procédé de fabrication selon la revendication 5 dans lequel la couche diélectrique en oxyde de silicium incorpore de l'azote, préférentiellement dans un ratio azote/oxygène inférieur à 0,5.

11. Procédé de fabrication selon l'une des revendications précédentes dans lequel la formation de la couche diélectrique (3) comprend la formation d'une partie au moins de la couche diélectrique sur le substrat donneur.

12. Procédé de fabrication selon la revendication précédente dans lequel l'application du traitement de surface comprend son application à la surface exposée de la face principale du substrat donneur.

13. Procédé de fabrication selon la revendication précédente dans lequel la formation d'une partie au moins de la couche diélectrique (3) sur le substrat donneur précède l'application du traitement de surface.

## Patentansprüche

1. Verfahren zur Herstellung einer Struktur (1), die eine Dünnschicht (4) umfasst, die mittels einer dielektrischen Schicht (3) auf einen Träger (2) übertragen ist, wobei der Träger eine elektrische Ladungen einfangende Schicht (2b) umfasst, die oberflächlich auf einem Basissubstrat (2a) angeordnet ist, wobei das Verfahren die folgenden Schritte umfasst:
- Bilden einer dielektrischen Schicht (3) auf einer freiliegenden Oberfläche einer sogenannten "Hauptseite" des Trägers und/oder auf einer freiliegenden Oberfläche einer sogenannten "Hauptseite" eines Donorsubstrats;
- Anwenden einer Oberflächenbehandlung auf die freiliegende Oberfläche der Hauptseite des Trägers und/oder auf die freiliegende Oberfläche der Hauptseite des Donorsubstrats, um darauf eine Barriereschicht gegen die Diffusion bestimmter atomarer Spezies zu bilden;
- Fügen des Trägers und des Donorsubstrats über deren jeweilige Hauptseiten, um eine Zwischenstruktur zu bilden;
- Entfernen wenigstens eines Teils des Donorsubstrats von der Zwischenstruktur, um die Dünnschicht zu bilden;
wobei das Verfahren **dadurch gekennzeichnet ist, dass** die auf wenigstens eine der freiliegenden Oberflächen angewendete Oberflächenbehandlung Folgendes umfasst:
- das Aussetzen der freiliegenden Oberfläche einem Sauerstoff umfassenden Plasma, um unter der Hauptoberfläche eine beschädigte Dicke auszubilden, gefolgt von
- dem Aussetzen der freiliegenden Oberfläche einem Stickstoff umfassenden Plasma, um die beschädigte Dicke zu nitrieren.

2. Verfahren zur Herstellung nach dem vorstehenden Anspruch, wobei das Donorsubstrat ein monokristallines piezoelektrisches Material umfasst.

3. Verfahren zur Herstellung nach Anspruch 1, wobei das Donorsubstrat ein monokristallines Siliziumsubstrat ist.

4. Verfahren zur Herstellung nach einem der vorstehenden Ansprüche, wobei das Basissubstrat (2a) ein monokristallines Siliziumsubstrat ist.

5. Verfahren zur Herstellung nach einem der vorstehenden Ansprüche, wobei die dielektrische Schicht (3) Siliziumoxid umfasst.

6. Verfahren zur Herstellung nach einem der vorstehenden Ansprüche, wobei die Einfangschicht (2b) aus polykristallinem Silizium besteht.

7. Verfahren zur Herstellung nach dem vorstehenden Anspruch, wobei das Bilden der dielektrischen Schicht (3) das Oxidieren der Einfangschicht (2b) umfasst.

8. Verfahren zur Herstellung nach dem vorstehenden Anspruch, wobei das Bilden der dielektrischen Schicht (3) dem Anwenden der Oberflächenbehandlung auf die freiliegende Oberfläche der Hauptseite des Trägers (2) vorausgeht.

9. Verfahren zur Herstellung nach Anspruch 7, wobei das Bilden der dielektrischen Schicht (3) auf das Anwenden der Oberflächenbehandlung auf die freiliegende Oberfläche der Hauptseite des Trägers (2) folgt.

10. Verfahren zur Herstellung nach Anspruch 5, wobei die dielektrische Siliziumoxidschicht Stickstoff enthält, vorzugsweise in einem Stickstoff/Sauerstoff-Verhältnis von weniger als 0,5.

11. Verfahren zur Herstellung nach einem der vorstehenden Ansprüche, wobei das Bilden der dielektrischen Schicht (3) das Bilden wenigstens eines Teils der dielektrischen Schicht auf dem Donorsubstrat umfasst.

12. Verfahren zur Herstellung nach dem vorstehenden Anspruch, wobei das Anwenden der Oberflächenbehandlung deren Anwenden auf die freiliegende Oberfläche der Hauptseite des Donorsubstrats umfasst.

13. Verfahren zur Herstellung nach dem vorstehenden Anspruch, wobei das Bilden wenigstens eines Teils der dielektrischen Schicht (3) auf dem Donorsubstrat dem Anwenden der Oberflächenbehandlung vorausgeht.

## Claims

1. Method for fabricating a structure (1) comprising a thin layer (4) transferred onto a substrate (2) by means of a dielectric layer (3), the substrate comprising an electric charge trapping layer (2b) arranged on the surface of a base substrate (2a), the method comprising the following steps:
- forming a dielectric layer (3) on an exposed surface of a so-called "main" face of the substrate and/or on an exposed surface of a so-called "main" face of a donor substrate;
- applying a surface treatment to the exposed surface of the main face of the substrate and/or to the exposed surface of the main face of the donor substrate in order to form thereon a barrier layer against the diffusion of certain atomic species;
- bonding the substrate and the donor substrate together via their respective main faces so as to form an intermediate structure;
- removing at least a portion of the donor substrate from the intermediate structure so as to form the thin layer;
the method being **characterised in that** the surface treatment applied to at least one of the exposed surfaces comprises:
- exposing the exposed surface to a plasma comprising oxygen so as to form a damaged thickness beneath the main surface, followed by
- exposing the exposed surface to a plasma comprising nitrogen so as to nitride the damaged thickness.

2. Method for fabricating according to the preceding claim, wherein the donor substrate comprises a monocrystalline piezoelectric material.

3. Method for fabricating according to claim 1, wherein the donor substrate is a monocrystalline silicon substrate.

4. Method for fabricating according to one of the preceding claims, wherein the base substrate (2a) is a monocrystalline silicon substrate.

5. Method for fabricating according to one of the preceding claims, wherein the dielectric layer (3) comprises silicon oxide.

6. Method for fabricating according to one of the preceding claims, wherein the trapping layer (2b) is made of polycrystalline silicon.

7. Method for fabricating according to the preceding claim, wherein forming the dielectric layer (3) comprises oxidising the trapping layer (2b).

8. Method for fabricating according to the preceding claim, wherein forming the dielectric layer (3) precedes applying the surface treatment to the exposed surface of the main face of the substrate (2).

9. Method for fabricating according to claim 7, wherein forming the dielectric layer (3) follows applying the surface treatment to the exposed surface of the main face of the substrate (2).

10. Method for fabricating according to claim 5, wherein the silicon oxide dielectric layer incorporates nitrogen, preferably at a nitrogen/oxygen ratio of less than 0.5.

11. Method for fabricating according to one of the preceding claims, wherein forming the dielectric layer (3) comprises forming at least a portion of the dielectric layer on the donor substrate.

12. Method for fabricating according to the preceding claim, wherein applying the surface treatment comprises applying the treatment to the exposed surface of the main face of the donor substrate.

13. Method for fabricating according to the preceding claim, wherein forming at least a portion of the dielectric layer (3) on the donor substrate precedes applying the surface treatment.
